(19) Europäisches Patentamt
European Patent Office
Office européen des brevets

(11) **EP 1 361 662 A1**

(12) **EUROPEAN PATENT APPLICATION**

(43) Date of publication:
**12.11.2003 Bulletin 2003/46**

(51) Int Cl.⁷: **H03M 13/45**, G11B 20/18, G11B 20/10, H03M 13/37

(21) Application number: **02258582.2**

(22) Date of filing: **12.12.2002**

(84) Designated Contracting States:
**AT BE BG CH CY CZ DE DK EE ES FI FR GB GR IE IT LI LU MC NL PT SE SI SK TR**
Designated Extension States:
**AL LT LV MK RO**

(30) Priority: **09.05.2002 KR 2002025632**

(71) Applicant: **SAMSUNG ELECTRONICS CO., LTD. Suwon-City, Kyungki-do (KR)**

(72) Inventors:
• **Kim, Ki-hyun**
**Yusong-gu, Daejeon Metropolitan-city (KR)**

• **Han, Sung-hyu**
**Gangnam-gu, Seoul (KR)**
• **Park, In-sik**
**Paldal-gu, Suwon-si, Gyeonggi-do (KR)**
• **Shim, Jae-seong**
**Seoul (KR)**

(74) Representative: **Robinson, Ian Michael**
**Appleyard Lees,**
**15 Clare Road**
**Halifax HX1 2HY (GB)**

(54) **Apparatus and method for generating soft output of signal passing through channel**

(57) Provided are an apparatus and method for generating a soft output of a signal. The method including inputting an input signal that is a discrete signal converted from an analog signal passing through a channel having predetermined characteristics such as a recording medium; setting a point in time, as a first reference point, at which a code of a value of the input signal is inverted, and detecting a predetermined number of inversion sections at the first reference point; setting points in time, as second reference points, when the input signal has a discrete value within the inversion section, and calculating all of error paths of target values at the each time, the target values including the values of the input signal at the second reference points and the values of signals at each time, and the error paths being a set of the target values; calculating accumulated errors for the error paths with the values of input signal within the inversion section and the values of the error paths, and calculating maximum values of the accumulated errors for the error paths at the second reference points; calculating a log likelihood relation (LLR) value using the maximum values at the second reference points; and replacing the values of the input signal within the inversion section of a predetermined range with the LLR values and outputting the LLR values. Accordingly, soft outputs of signals, which pass through a channel having predetermined characteristics, are generated for error paths of only the signals that intersect at a zero point, thereby remarkably reducing calculation time.

FIG. 1A

**EP 1 361 662 A1**

**Description**

The present invention relates to an apparatus and method for generating a soft output, and more particularly, to an apparatus and method for generating a soft output of a signal that passes through a channel having a predetermined characteristics.

Conventionally, a soft output of a signal passing through a channel is obtained using a maximum posteriori probability (MAP) algorithm, or a soft output viterbi algorithm (SOVA), or by calculating a log likelihood relation (LLR).

The MAP algorithm is an algorithm having a maximum probability that is expressed as $P\{d_k=i\backslash observation\}$, wherein $d_k$ denotes a kth input and $i$ may be 1 or 0. That is, according to the MAP algorithm, a signal of a regular size is received and a posteriori probability for each bit is calculated. The SOVA algorithm multiplies a result obtained using a viterbi algorithm by reliability and outputs the result. According to the viterbi algorithm, a final value is obtained through operation of a regular sequence, and thus, it requires updating the reliability of a mean value of the operation. The calculation of the LLR is to detect every possibility for cases that can be output by a channel, and is different from the SOVA algorithm in that it detects an output of each bit. The SOVA algorithm calculates a sequence value, which can be output, for a sequence of a regular size.

The above conventional methods are disadvantageous, however, in that a lot of time is spent on obtaining a soft output of a signal passing through a channel, since a decoding process is performed in frame units in the case of the MAP algorithm or all error paths and outputs are detected in the case of the SOVA algorithm and the calculation of the LLR. In particular, repetitively performing a decoding process results in an increase in a delay in time.

It is an aim of the present invention to provide a method of setting an error path used in obtaining a soft output of a signal.

Another aim of the present invention to provide an apparatus and method for obtaining a soft output of a signal, ideally with a shorter calculation time than conventional methods.

According to the present invention there is provided an apparatus and method as set forth in the appended claims. Preferred features of the invention will be apparent from the dependent claims and the description which follows.

In one aspect of the present invention there is provided a method for setting an error path of a signal, the method including inputting a first signal that is a predetermined discrete signal; setting a time at which the first signal has a discrete value as a reference time; and sampling all of combinations of a predetermined number of all possible values at times before and after the reference time at which the first signal has the discrete value, as well as the discrete value for the first signal at the reference time.

Preferably, inputting a first signal further includes setting a time of a predetermined range that includes a point of times at which a code of the discrete value of the first signal is inverted, and during setting a time, a time at which the first signal has the discrete value is set as a reference time within the time of the predetermined range.

In another aspect of the present invention there is provided a method for generating a soft output of a signal, the method including inputting an input signal that is a discrete signal converted from an analog signal passing through a channel having predetermined characteristics such as a recording medium; setting a point in time, as a first reference point, at which a code of a value of the input signal is inverted, and detecting a predetermined number of inversion sections at the first reference point; setting points in time, as second reference points, when the input signal has a discrete value within the inversion section, and calculating all of error paths of target values at the each time, the target values including the values of the input signal at the second reference points and the values of signals at each time, and the error paths being a set of the target values; calculating accumulated errors for the error paths with the values of input signal within the inversion section and the values of the error paths, and calculating maximum values of the accumulated errors for the error paths at the second reference points; calculating a log likelihood relation (LLR) value using the maximum values at the second reference points; and replacing the values of the input signal within the inversion section of a predetermined range with the LLR values and outputting the LLR values.

Preferably, setting an instant of time further includes setting times at which the input signal has a discrete value as second reference points, and calculating all of error paths of target values at the each time, the target values including the values of the input signal at the second reference points and the values of signals at each time, and the error paths being a set of the target values; and setting instants of time further comprises setting a point in time, at which a code of the value of the input signal is inverted, as a first reference point, and detecting an inversion section where the input signal has a predetermined number of values.

In yet another aspect of the present invention there is provided an apparatus for generating a soft output of a signal, the apparatus comprising an inversion section detection unit receiving an input signal and detecting an inversion section where the input signal has a predetermined number of values at a first reference point, the input signal being a discrete signal converted from an analog signal passing through a channel having predetermined characteristics, the channel including a recording medium, and the first reference point being a point in time when codes of the values of the input signal are inverted; an accumulated error operation unit calculating all error paths at second reference points, calculating accumulated errors for the error paths using the values of the input signal within an inversion section and the values of the error paths at the second reference points, and calculating maximum values of accumulated error values for the error paths, the second reference points being points in time when the input signal has discrete values within the inversion section, and the error paths being a set of target values that are values the input signal has at each time and the values of the input signal at the second reference points; an LLR value calculating unit calculating an LLR value using the maximum values at the second reference points; and a signal value conversion unit changing the values of the input signal within a predetermined range of the inversion section into the LLR values and outputting the LLR values.

Preferably, the accumulated error operation unit receives the input signal that is a discrete signal converted from an analog signal passing through a channel having predetermined characteristics such as a recording medium, the accumulated error operation unit calculates all error paths including a set of target values and the values of the input signal at the second reference points, the target values being all possible values the input signal has at each time if the second reference points are each of times when the input signal has the discrete value, the accumulated error operation unit for calculating accumulated errors for the error paths using the values of the input signal within the inversion section and the values of the error paths at the second reference points and for calculating maximum values of the accumulated errors for the error paths. Also, the inversion section detection unit detects the inversion section where the input signal has a predetermined number of values at the first reference point, the first reference point where the code of the value of the input signal is inverted.

For a better understanding of the invention, and to show how embodiments of the same may be carried into effect, reference will now be made, by way of example, to the accompanying diagrammatic drawings in which:

Figures 1A and 1B are block diagrams of an apparatus for generating a soft output of a signal that passes through a channel according to a preferred embodiment of the present invention;

Figure 2 is a flowchart illustrating a method of generating a soft output of a signal that passes through a channel according to a preferred embodiment of the present invention; and

Figure 3 is a graph illustrating a comparison of a soft output obtained according to the present invention with a hard output obtained according to a partial response maximum likelihood (PRML).

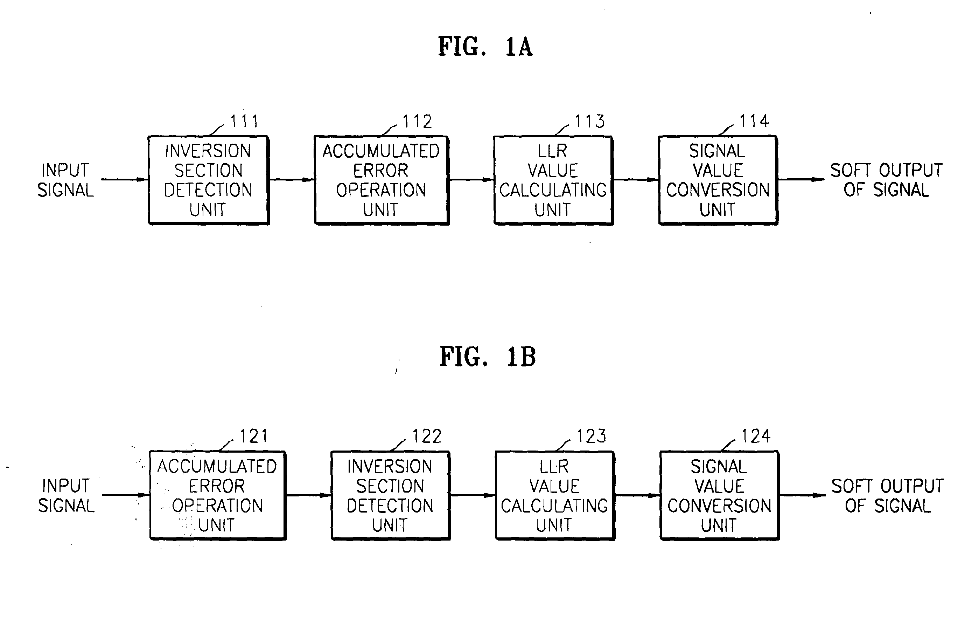

Figures 1A and 1B are block diagrams of preferred embodiments of an apparatus for generating a soft output according to the present invention. Referring to Figures 1A and 1B, accumulated error operation units 112 and 121 calculate an error value by the following equation:

$$M(n,k) = -(r_n - c_k)^2 \ or \ -|r_n - c_k|, \ (k = 1, 2, 3, 4) \tag{1}$$

wherein $r$ denotes an input signal, $C_1$, $C_2$, $C_3$, and $C_4$ denote target output values according to a channel, and $n$ denotes a signal time that is a reference point for calculating an error value.

Next, an accumulated error value for a signal path is calculated by combination of the error value $M$ according to the characteristics of a channel as follows:

$$Er_{i,n} = ...M(n-1, k_{n-1}) + M(n, k_n) + M(n+1, k_{n+1})..., \tag{2}$$

wherein $i$ denotes the number of a signal path and $n$ denotes a signal time that is a reference point for calculating an error value.

Inversion section detection units 111 and 122 check a code for $(r_{n-1} \times r_n)$ and a code for $r_{n-1}$ to detect a change in the code for and the direction of the input signal $r$, and set an inversion section of a predetermined size that includes an inversion value of the detected input signal.

Log-likelihood-ratio (LLR) calculating units 113 and 132 calculate LLR values. An LLR value is obtained by dividing the input signal r by a probability, i.e., $(P(r=1|C)/P(r=0|C))$, and taking logarithms of the value. To simplify this calculation, a maximum value of an error for each signal path, which is calculated by the accumulated error operation units 112 and 121, is used in the present invention.

Signal value converting units 114 and 124 changes the inversion value of the input signal $r$ in the inversion section into the LLR value and outputs the LLR value.

Meanwhile, as shown in Figures 1A and 1B, the locations of the accumulated error operation units 112 and 121, and those of the inversion section detection units 111 and 122 may be switched if necessary.

Hereinafter, a method for generating a soft output according to the present invention will be described. First, an analog signal, which passes through a channel having predetermined characteristics, is converted into a discrete signal and then input to an apparatus for generating a soft output of the signal. Next, an accumulated error for the path of the input signal is calculated.

For instance, if the number of channels is 121, target values can be expressed as $Cn=\{1, 0.5, -0.5, -1\}$. In this case, combinations of four accumulated errors for one path for three signals are expressed in Table 1. Here, inversion of a signal occurs between signal times *n-1* and *n*, where a signal for a signal time *n-1* is positive.

[Table 1]

|          | n-2 | n-1 | n    | N+1  |
|----------|-----|-----|------|------|
| $Er_{1,n}$ | 1   | 0.5 | -0.5 | 1    |
| $Er_{2,n}$ | 0.5 | 0.5 | -0.5 | -0.5 |
| $Er_{3,n}$ | 0.5 | 0.5 | -0.5 | 1    |
| $ER_{4,n}$ | 1   | 0.5 | -0.5 | -0.5 |

Once the combinations illustrated in Table 1 are selected, accumulated errors are calculated by equation, $Er_{i,n}=M(n-2,K_{n-2,i}) + ...+ M(n+1, K_{n+1,i})$. As a result, when three signals intersect at a zero point, i.e., these signals are inverted, accumulated errors for paths of the three signals are $Er_{i,n-1}$, $Er_{i,n}$, and $Er_{i,n+1}$, respectively.

Thereafter, the location and direction at which a code of the input signal changes are checked. At this time, codes of continuous two signals are checked as described above.

Next, if it is acknowledged that these signals intersect at the zero point, a maximum one of accumulated error values per signal path is selected. In the event that the intersection of the signals at the zero point is made between *n-1* and *n,* where a signal for *n-1* is positive, maximum values for the accumulated errors $Er_{i,n-1}$, $Er_{i,n}$, and $Er_{i,n+1}$ are calculated.

Next, LLR values are calculated using the maximum values per signal path. If the maximum values are $MEr_{n-1}$, $MEr_n$, $MEr_{n+1}$, LLR values are obtained as $LLR(n-1)=MEr_n=MEr_{n-1}$ and $LLR(n)=MER_{n+1}-MEr_n$.

After calculation of the LLR values, signal values before and after the zero point, e.g., the value of an input signal within an inversion section, are replaced with the calculated LLR values and output. That is, the signal values *r (n-1)* and *r(n)* are replaced with the LLR values *LLR(n-1)* and *LLR(n)* and output.

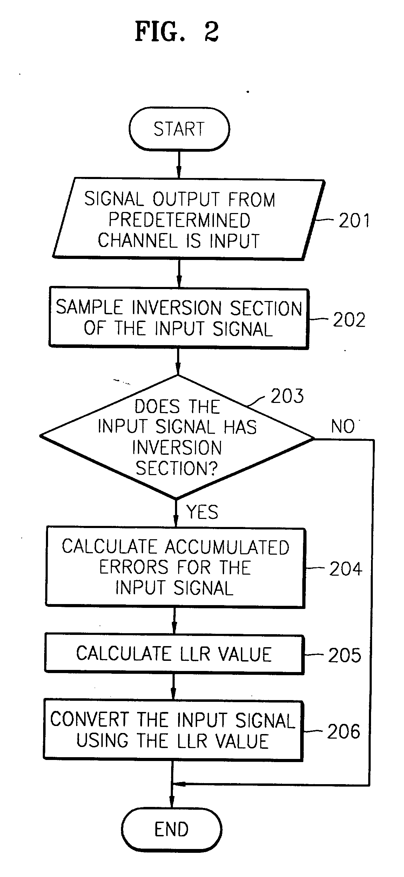

Figure 2 is a flowchart illustrating a method of generating a soft output of a signal passing through a path according to a preferred embodiment of the present invention.

Referring to Figure 2, an output signal, which passes through a channel having predetermined characteristics, is input to an apparatus for generating a soft output in step 201, and an inversion section of the input signal is sampled in step 202. Next, it is checked if the sampled inversion section is substantially present in step 203. If there is an inversion section, accumulated errors for the input signal are calculated in step 204. Next, an LLR value is calculated in step 205, and the input signal is converted using the LLR value to generate a soft output thereof in step 206.

However, if it is checked in step 203 that there is no inversion section, there is no reason for generating a soft output of the input signal and thus all steps are terminated.

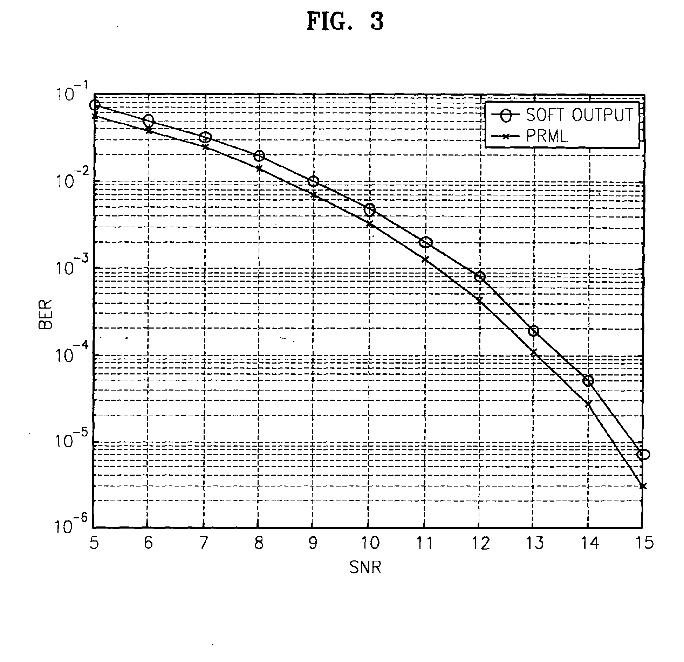

Figure 3 is a graph illustrating a comparison of a soft output obtained according to the present invention with a hard output obtained according to a partial response maximum likelihood (PRML) if there are 121 channels of manner. The soft output shown in Figure 3 is the result obtained by passing a soft output, according to the present invention, through a hard detector to compare it with a hard output.

The present invention can be embodied as a computer readable code in a computer readable medium. Here, the computer readable medium may be any recording apparatus capable of storing data that can be read by a computer system, e.g., a read-only memory (ROM), a random access memory (RAM), a compact disc (CD)-ROM, a magnetic tape, a floppy disk, an optical data storage device, and so on. Also, the computer readable medium may be a carrier wave that transmits data via the Internet, for example. The computer readable recording medium can be remotely installed in a computer system connected to a network, and stored and accomplished as a computer readable code by a distributed computing environment.

As described above, soft outputs of signals, which pass through a channel having predetermined characteristics, are generated for error paths of only the signals that intersect at a zero point. Therefore, compared to prior soft output generation methods, the method according to the present invention does not require performing a decoding process on signals in frame units, thereby remarkably reducing calculation time.

While this invention has been particularly shown and described with reference to preferred embodiments thereof, it will be understood by those skilled in the art that various changes in form and details may be made therein without departing from the scope of the invention as defined by the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

**Claims**

1. A method for setting an error path of a signal, comprising:

   inputting a first signal that is a predetermined discrete signal;

   setting a time at which the first signal has a discrete value as a reference time; and

   sampling all of combinations of a predetermined number of all possible values at times before and after the reference time at which the first signal has the discrete value, as well as the discrete value for the first signal at the reference time.

2. The method of claim 1, wherein inputting a first signal further comprises setting a time of a predetermined range that includes a point of times at which a code of the discrete value of the first signal is inverted, and during setting a time, a time at which the first signal has the discrete value is set as a reference time within the time of the predetermined range.

3. A method for generating a soft output of a signal, comprising:

   inputting an input signal that is a discrete signal converted from an analog signal passing through a channel having predetermined characteristics such as a recording medium;

   setting a point in time, as a first reference point, at which a code of a value of the input signal is inverted, and detecting a predetermined number of inversion sections at the first reference point;

   setting points in time, as second reference points, when the input signal has a discrete value within the inversion section, and calculating all of error paths of target values at the each time, the target values including the values of the input signal at the second reference points and the values of signals at each time, and the error paths being a set of the target values;

   calculating accumulated errors for the error paths with the values of input signal within the inversion section and the values of the error paths, and calculating maximum values of the accumulated errors for the error paths at the second reference points;

   calculating a log likelihood relation (LLR) value using the maximum values at the second reference points; and

   replacing the values of the input signal within the inversion section of a predetermined range with the LLR values and outputting the LLR values.

4. The method of claim 3, wherein setting an instant of time further comprises setting times at which the input signal has a discrete value as second reference points, and calculating all of error paths of target values at the each time, the target values including the values of the input signal at the second reference points and the values of signals at each time, and the error paths being a set of the target values; and

setting instants of time further comprises setting a point in time, at which a code of the value of the input signal is inverted, as a first reference point, and detecting an inversion section where the input signal has a predetermined number of values.

**5.** An apparatus for generating a soft output of a signal, comprising:

an inversion section detection unit (111) receiving an input signal and detecting an inversion section where the input signal has a predetermined number of values at a first reference point, the input signal being a discrete signal converted from an analog signal passing through a channel having predetermined characteristics, the channel including a recording medium, and the first reference point being a point in time when codes of the values of the input signal are inverted;

an accumulated error operation unit (112) calculating all error paths at second reference points, calculating accumulated errors for the error paths using the values of the input signal within an inversion section and the values of the error paths at the second reference points, and calculating maximum values of accumulated error values for the error paths, the second reference points being points in time when the input signal has discrete values within the inversion section, and the error paths being a set of target values that are values the input signal has at each time and the values of the input signal at the second reference points;

an LLR value calculating unit (113) calculating an LLR value using the maximum values at the second reference points; and

a signal value conversion unit (114) changing the values of the input signal within a predetermined range of the inversion section into the LLR values and outputting the LLR values.

**6.** The apparatus of claim 5, wherein the accumulated error operation unit (112) receives the input signal that is a discrete signal converted from an analog signal passing through a channel having predetermined characteristics such as a recording medium, the accumulated error operation unit calculates all error paths including a set of target values and the values of the input signal at the second reference points, the target values being all possible values the input signal has at each time if the second reference points are each of times when the input signal has the discrete value, the accumulated error operation unit for calculating accumulated errors for the error paths using the values of the input signal within the inversion section and the values of the error paths at the second reference points and for calculating maximum values of the accumulated errors for the error paths, and the inversion section detection unit (111) detects the inversion section where the input signal has a predetermined number of values at the first reference point, the first reference point where the code of the value of the input signal is inverted.

**7.** A computer-readable recording medium for recording a program that can execute a method of any one of claims 1 through 4 in a computer.

## FIG. 1A

INPUT SIGNAL → | INVERSION SECTION DETECTION UNIT (111) | → | ACCUMULATED ERROR OPERATION UNIT (112) | → | LLR VALUE CALCULATING UNIT (113) | → | SIGNAL VALUE CONVERSION UNIT (114) | → SOFT OUTPUT OF SIGNAL

## FIG. 1B

INPUT SIGNAL → | ACCUMULATED ERROR OPERATION UNIT (121) | → | INVERSION SECTION DETECTION UNIT (122) | → | LLR VALUE CALCULATING UNIT (123) | → | SIGNAL VALUE CONVERSION UNIT (124) | → SOFT OUTPUT OF SIGNAL

EP 1 361 662 A1

# FIG. 2

```
              ┌─────────┐
              │  START  │
              └─────────┘
                   │
                   ▼
        ╱───────────────────────╲
       ╱  SIGNAL OUTPUT FROM      ╲ ─── 201
      ╱     PREDETERMINED          ╲
     ╱      CHANNEL IS INPUT        ╲
      ╲_____╱
                   │
                   ▼
        ┌───────────────────────┐
        │ SAMPLE INVERSION SECTION │ ─── 202
        │   OF THE INPUT SIGNAL    │
        └───────────────────────┘
                   │
                   ▼
              ◇───────◇  203
            ◇  DOES THE  ◇
          ◇  INPUT SIGNAL HAS  ◇─── NO
          ◇    INVERSION      ◇
            ◇   SECTION?    ◇
              ◇───────◇
                   │ YES
                   ▼
        ┌───────────────────────┐
        │ CALCULATE ACCUMULATED  │ ─── 204
        │    ERRORS FOR THE      │
        │     INPUT SIGNAL       │
        └───────────────────────┘
                   │
                   ▼
        ┌───────────────────────┐
        │   CALCULATE LLR VALUE  │ ─── 205
        └───────────────────────┘
                   │
                   ▼
        ┌───────────────────────┐
        │ CONVERT THE INPUT SIGNAL │ ─── 206
        │   USING THE LLR VALUE    │
        └───────────────────────┘
                   │
                   ▼
              ┌─────────┐
              │   END   │
              └─────────┘
```

FIG. 3

# EP 1 361 662 A1

| | European Patent Office | EUROPEAN SEARCH REPORT | Application Number EP 02 25 8582 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | WO 01 76079 A (ADVANCED HARDWARE ARCHITECTURE) 11 October 2001 (2001-10-11) * the whole document * --- | 1-7 | H03M13/45 G11B20/18 G11B20/10 H03M13/37 |
| A | US 6 216 148 B1 (CHAN IVAN TIN-YAM ET AL) 10 April 2001 (2001-04-10) * the whole document * --- | 1-7 | |
| A | US 5 583 705 A (CHE XIAODONG ET AL) 10 December 1996 (1996-12-10) * the whole document * ----- | 1-7 | |
| | | | TECHNICAL FIELDS SEARCHED (Int.Cl.7) |
| | | | H03M G11B |

| The present search report has been drawn up for all claims | | |
|---|---|---|
| Place of search THE HAGUE | Date of completion of the search 11 September 2003 | Examiner Devergranne, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**EP 1 361 662 A1**

# ANNEX TO THE EUROPEAN SEARCH REPORT
## ON EUROPEAN PATENT APPLICATION NO.

EP 02 25 8582

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2003

| Patent document cited in search report | | Publication date | Patent family member(s) | | Publication date |
|---|---|---|---|---|---|
| WO 0176079 | A | 11-10-2001 | AU | 8929601 A | 15-10-2001 |
| | | | CA | 2404984 A1 | 11-10-2001 |
| | | | EP | 1281241 A2 | 05-02-2003 |
| | | | WO | 0176079 A2 | 11-10-2001 |
| | | | US | 2002026615 A1 | 28-02-2002 |
| US 6216148 | B1 | 10-04-2001 | NONE | | |
| US 5583705 | A | 10-12-1996 | US | 5493454 A | 20-02-1996 |
| | | | DE | 69524525 D1 | 24-01-2002 |
| | | | DE | 69524525 T2 | 23-05-2002 |
| | | | EP | 0706173 A1 | 10-04-1996 |
| | | | JP | 8115503 A | 07-05-1996 |

EPO FORM P0459

For more details about this annex : see Official Journal of the European Patent Office, No. 12/82

11